(19)

Europäisches Patentamt

European Patent Office

Office européen des brevets

(11) **EP 1 995 782 A2**

(12) **EUROPEAN PATENT APPLICATION**

(43) Date of publication:
26.11.2008 Bulletin 2008/48

(51) Int Cl.:
*H01L 27/144* (2006.01)    *G06K 7/10* (2006.01)
*H01L 31/105* (2006.01)

(21) Application number: 08250977.9

(22) Date of filing: 19.03.2008

(84) Designated Contracting States:
AT BE BG CH CY CZ DE DK EE ES FI FR GB GR HR HU IE IS IT LI LT LU LV MC MT NL NO PL PT RO SE SI SK TR
Designated Extension States:
AL BA MK RS

(30) Priority: 16.05.2007 US 749220

(71) Applicant: NCR Corporation
Dayton, Ohio 45479 (US)

(72) Inventor: Kwan, Sik Piu
Suwanee, GA 30024 (US)

(74) Representative: MacLeod, Roderick William et al
NCR Limited
Architecture & Technology
Discovery Centre
3 Fulton Road
Dundee DD2 4SW (GB)

(54) **A device and system for a low noise photodiode in a barcode scanner**

(57) An apparatus and system that uses an improved photo detector in a laser scanner to scan bar codes. The photo detector has an increased signal to noise ratio, which improves the ability to detect faint reflected laser light. The signal to noise ratio is increased by reducing the thermal noise of the photo detector. The increased signal to noise ratio improves the laser bar code scanner's ability to read smaller bar codes as well as improving the read range of the scanner.

FIG. 1

EP 1 995 782 A2

**Description**

A device described herein relates generally to improvements in laser bar code scanners. More particularly, the invention relates to increasing the signal to noise ratio for a photodiode.

Bar code scanners are used in a wide variety of applications, such as retailing, healthcare, inventory control, customer identification and many other applications. Bar code scanners are adapted to scan a bar code that is typically attached to or printed on an object. When the object is placed within the field of view of the scanner, the scanner is able to read the bar code. Information is encoded into a bar code by varying the width of the bars and spaces that make up the bar code. Some objects have only a small space where the bar code can be located, which limits the maximum size of the bar code. Bar code standards, such as the "Reduced-sized Symbols" (RSS) standard, have been established to minimize the size of the bar code and thus the area needed for a bar code.

A laser bar code scanner reads a bar code by moving a laser beam across the bar code and then detecting the different intensity of laser light reflected from the bar code. A photo detector is used to detect the amount of laser light being reflected. The intensity of the reflected laser light varies as the laser beam moves across the dark (bar) and light (spaces) areas of the bar code. The bar code scanner will periodically read the photo detector to determine the intensity of the reflected laser light, as the laser beam is moved or scanned across the bar code. The different intensities are used to decode or read the bar code being scanned. Decreasing the size of a bar code reduces the amount of the reflected laser light and reduces the difference in intensity between laser light reflected from the bars and spaces of the bar code. This reduction in reflected laser light makes it increasingly more difficult to detect and accurately read a bar code. At some point, the intensity of the reflected laser light is so low that the electrical noise, inherent to the photo detector, will make it impossible to accurately read the bar code.

According to a first aspect of the present invention there is provided a light sensing apparatus , comprising: a semiconductor substrate; a diode fabricated on the semiconductor substrate where the diode has a series resistance of less than 100 ohms and a junction capacitance of less than 8 pico-farads; and a protective package that houses the semiconductor substrate and that has a transparent window allowing light to pass through and strike the diode causing a current to flow.

According to a second aspect of the present invention there is provided a photodetector apparatus having an improved signal to noise ratio, the apparatus comprising: a photodiode where the series resistance is less than 100 ohms and the junction capacitance is less than 8 pico-farads.

Preferably the series resistance of the photodiode is between 60-84 ohms.

Most preferably the junction capacitance of the photodiode is between 5.8-7.5 pico-farads.

Preferably the series resistance of the photodiode is about 80 ohms and the junction capacitance is about 6.7 pico-farads.

According to a third aspect of the present invention there is provided a laser scanning system laser scanning system having an improved signal to noise ratio for detecting reflected laser light, the system comprising: a laser device adapted to generate a laser beam; a beam directing device adapted to direct the laser beam across a code; a photodiode adapted to detect reflected laser light from the laser beam moving across the code and to produce electrical signals that are proportional to the detected light where the series resistance of the photodiode is less than 100 ohms and the junction capacitance is less than 8 pico farads; and a processor module adapted to process the electrical signals from the photodiode to generate information about the code.

Embodiments of the present invention will now be described, by way of example, with reference to the accompanying drawings, in which:

FIG. 1 is an illustration of an embodiment of a laser scanning system.

FIG. 2 is a high-level flow diagram illustrating an example method for scanning an optical code using a laser scanning device.

FIG. 3 is a across section illustration of a photodiode.

FIG. 4 is an illustration of a model of an equivalent electrical circuit showing the noise sources for a photodiode.

In the following description, numerous details are set forth to provide an understanding of the claimed invention. However, it will be understood by those skilled in the art that the claimed invention may be practiced without these details and that numerous variations or modifications from the described embodiments are possible.

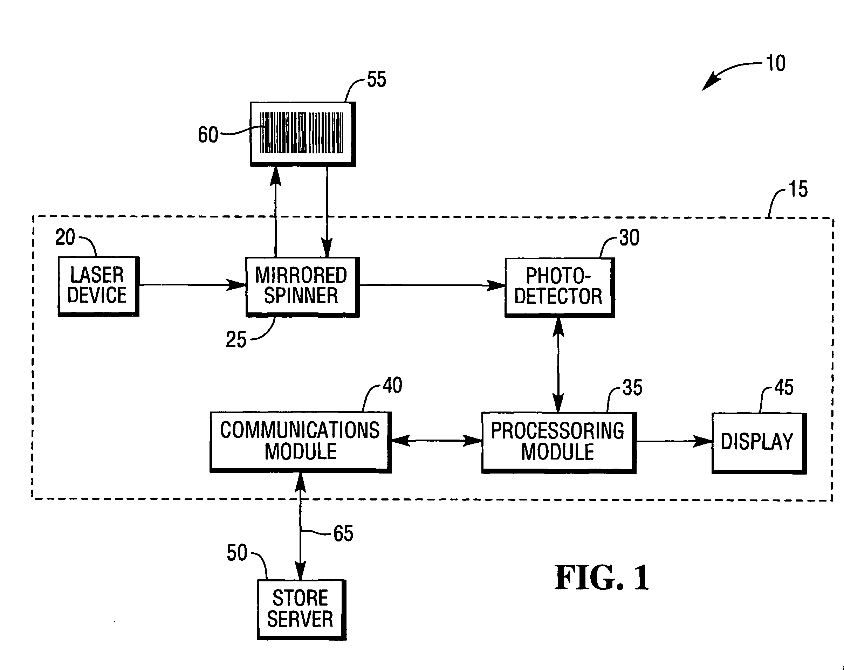

FIG. 1 provides an illustration, in block form, of an embodiment of a laser scanning system 10, which is used to scan an optical bar code 60. The laser scanning system 10 comprises a laser scanner 15, a store server 50 and a bar code 60 printed on a label 55. The store server 50 is connected to one or more laser scanners 15 over a network 65. The network 65 can be a wired or wireless system or a combination of both. In some embodiments, the store server 50 is physically removed from the store where the laser scanner 15 is located.

The laser scanner 15 comprises: a laser device 20 that generates a laser beam, a rotatable mirrored spinner 25, a photo detector 30 that detects reflected laser beam light, a processor module 35, a display 45, and communication module 40. The processor module 35 comprises a processor, memory, stored software instructions and control/interface logic necessary to control the other components of the laser scanner 15.

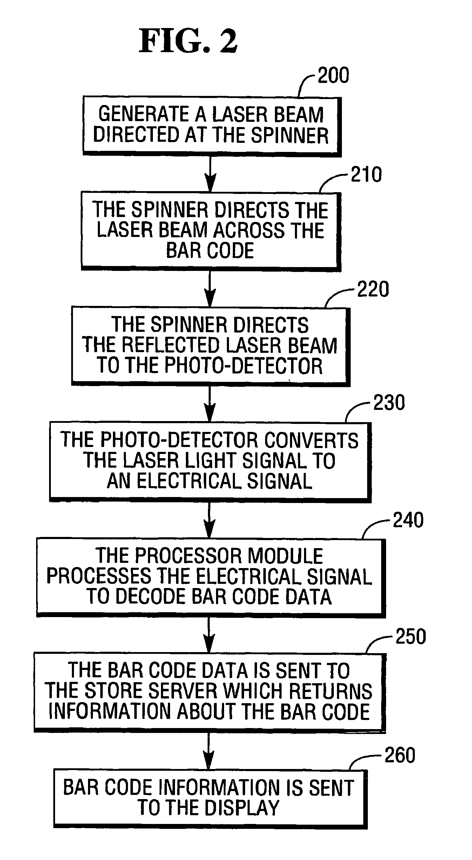

FIG. 2 illustrates a functional diagram of the laser scanner system 10. In step 200, the laser device 20 generates a laser beam that is directed at the mirrored spinner 25. In step 210, the rotating mirrored spinner 25 directs the laser beam so that is moves across the surface of the bar code 60. In other embodiments, different types of devices are used to direct the laser beam across the surface of the bar code 60. While all of the devices will direct the laser beam, not all use a rotating spinner device (e.g., a tiltable minor can be used). As the laser beam moves across the surface of the bar code 60, the bars and spaces that form the bar code 60 reflect different amounts of laser light. In step 220, the rotating mirrored spinner 25 also directs the reflected laser light to the photo detector 30. In step 230, the photo-detector 30 converts the received laser light signal to an electrical signal proportional to the intensity and duration of the received laser light signal. In step 240, the processor module processes the electrical signals received from the photo-detector 30 to decode the bar code 60. In step 250, the decoded bar code data is sent to the store server 50, which returns information about the bar code 60. The information from the store server 50 may include a price, a description, or an action that the scanner should take. In step 260, the returned information is sent to the display 45.

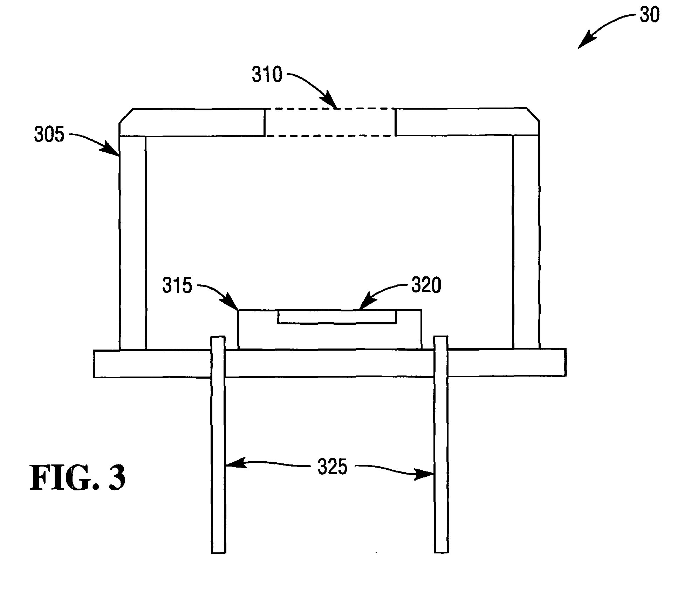

The photo-detector 30 is a photo-diode device that converts light energy to electrical energy. A cross section of a photodiode device is illustrated in FIG. 3. The photodiode is a p-n junction 320 fabricated on a semiconductor substrate 315 and housed in a package 305 with a transparent window 310 that allows light to penetrate and strike the p-n junction. In some embodiments, the photo-diode uses a p-in junction. When light of sufficient photon energy strikes the photodiode, it excites an electron creating a mobile electron and a positively charged electron hole, also called charge carriers. If the absorption of the photons occurs in the p-n junction's depletion region, or one diffusion length away from it, the resulting carriers are swept from the junction by the built-in field of the depletion region, producing a current called the photocurrent. The photocurrent is proportional to the amount and duration of light energy that strikes the photo-diode. The photodiode has two external pins 325 that connect to the p-n junction. One is the anode (positive) and the other is the cathode (negative). When a photo-diode is operated in this manor, it is said to be operating in a photovoltaic mode. The photovoltaic mode of operation is preferred for low frequency applications (generally up to 350 KHz).

Laser scanning applications are considered high frequency, low light applications and thus are not suited to operate in the photovoltaic mode. To improve the response speed, low light sensitivity, and linearity of the photo-diode, laser scanning application operate the photo-diode in a photoconductive mode. In photoconductive mode, a reversed bias voltage is placed across the photo-diode (i.e., the cathode has a positive voltage when referenced to the anode). The current embodiment operates the photo-diode in photoconductive mode and uses a reverse bias voltage of -24 volts. Other embodiments may use a reverse bias voltage that is substantially different while still obtaining acceptable results from the photo-diode.

The reduction in bar code size has reduced the duration and the amount of laser light reflected from the bar code to the photo-diode. For example, in applications using five mil wide bar codes, the collection time per bar can be a little as 0.35 microseconds and the photocurrents generated from the laser light reflected from the bar code can be in the range of 10-150 nano-amps. This approaches the performance limit of photodiodes.

The optics used in a laser scanner are designed to have a least one location that is optimal for reading a bar code. The bar code is also readable when it is moved a certain distance away from the optimal read location but at some point, the bar code will move to a point where the laser scanner will fail to read the bar code. The read range of a laser scanner is defined as the distance over which a bar code can be successfully read. It is desirable to have a large read range to increase the probability that a bar code will pass through the read range of the laser scanner and be successfully read. One parameter that affects the read range of a laser scanner is the signal to noise ratio (SNR) of the photo-diode used to detect the reflected laser light. Reducing the SNR of the photodiode makes it more difficult to read small bar codes, which reduces the read range of the scanner when reading small bar codes.. Similarly, increasing the SNR makes it easier to read small bar codes, which increases the read range of the scanner.

Photodiodes have some amount of inherent noise. Lowering the inherent noise of the photodiode has the effect of increasing the SNR, which improves the probability of successfully reading a bar code. After careful examination and analysis, the dominant source of noise in the photodiode was determined to be the thermal noise from the series resistance of the photodiode. This finding was a contradiction to the previously held belief that the dominant source of noise was shot noise from dark current. (Dark current is the current that flows in the absents of light.)

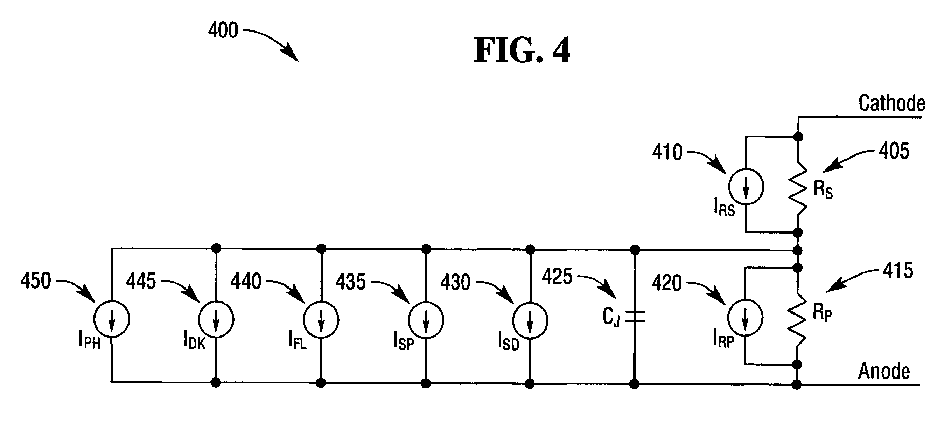

FIG. 4 is an illustration of an equivalent electrical circuit model 400 showing the dominant sources of noise and other currents in a photodiode. $R_s$ is the series resistance 405 for the photodiode and is approximately 200 ohms in a standard photodiode. The thermal noise from the series resistance is modeled as current source $I_{RS}$ 410 and is approximately 9.1 pico-amps. $R_p$ is the shunt resistance 415 and is 500 mega-ohms. The thermal noise from the shunt resistance

$R_p$ is modeled as current source $I_{RP}$ 420 and is approximately 0.006 pico-amps. The junction capacitance $C_J$ 425 is approximately 11 pico-farads and is responsible for the transmission of the thermal noise from the series resistance. Lowering the junction capacitance reduces the transmission of thermal noise and improves the SNR of the photodiode. $I_{SD}$ 430 is the shot noise from the dark current in the photodiode and is approximately 0.03 pico-amps. $I_{SP}$ is the shot noise from the photocurrent in the photodiode and is approximately 0.04 pico-amps. Defects in the silicon substrate cause flicker noise, which is modeled as current source $I_{FL}$ 440 and is approximately 0.02 pico-amps. These five current sources ($I_{RS}$, $I_{RP}$, $I_{SD}$, $I_{SP}$ and $I_{FL}$) represent the dominant sources of noise in the photodiode. $I_{RS}$ is the predominate source of noise at 9.1 pico-amps, which is 91 times larger the other four sources of noise combined.

$I_{DK}$ 445 is the current source that represents the dark current in the photodiode or the current that flows when no light is present at the p-n junction. The dark current may vary from pico-amps to a few nano-amps depending upon the p-n junction area and process used to build the photodiode. The dark current is treated as an offset that is subtracted from the output of the photodiode. Finally, $I_{PH}$ 450 is a current source that represents the photocurrent, which is proportional to the amount of light energy that is absorbed by the photodiode over a specific time period. When collecting the faint reflected laser light from a small bar code, the photocurrent is in the range of 10 - 150 nano-amps.

Thermal noise voltage from the series resistance of the photodiode can be represented by the following formula:

$$\textbf{Thermal Noise [in V/rtHz]} = \textbf{SQRT(4kTR}_S\textbf{)}$$

k = Boltzmann's constant
T = Temperature in Kelvin
$R_S$ = Series resistance of the photodiode

From this formula, it can be seen that reducing the value of $R_S$ (series resistance) reduces the thermal noise voltage resulting from the series resistance.

There are two predominate applications that use large volumes of photodiodes. The first is optical or fiber optics based communications. Fiber optic applications are known to use high power and high data rates. The photocurrents generated in these applications are in the range of 2 to 80 micro-amps (approximately 500 time larger that in bar code applications). The relatively high photocurrents easily over power the thermal noise from the series resistance of the photodiode making the value of the series resistance of little importance. The second group of applications is used to detect extremely faint light such as a star or a night vision system. These applications detect very low levels of light but have relatively long exposure durations (collection times). Some applications have a collection time of 1 second, which would be 2.8 million times longer than the 0.35 microseconds of collection time that can be experienced by a laser scanner reading a 5-mil wide bar. The long collection times allows the thermal noise from the series resistance to cancel itself out. Since the thermal noise is random, statistics and measurements show that the effects of the noise will cancel out, if the collection time is sufficiently long. A collection time of one millisecond is sufficient time for the thermal noise to cancel out.

In both of the above types of applications, there is no requirement or need to minimize the thermal noise from series resistance. In the absence of a performance requirement, the economics of production (what value allows the highest production rates) govern the process. Actual measurements of production photodiodes show the series resistance to be between 161 - 270 ohms and the junction capacitance to be between 8.6 - 9.8 pico-farads.

To further demonstrate a lack of perceived importance of the thermal noise from series resistance, it was discovered that three major manufacturers of the photodiode amplifiers (Texas Instruments, Analog Devices, and National Semiconductor) simulated their photodiode amplifier circuit without using a series resistance or accounting for thermal noise from the series resistance. The implication being that they believe the series resistance has so little significance, it could be omitted from the circuit model. Actual measurements show the photodiodes have noise values that are significantly higher than what is predicted by simulations using the manufacturer's model. These noise values are ignored by the other applications but are significant in laser scanning applications.

A number of custom photodiodes where specifically fabricated to have a reduced series resistance while having a low or lower junction capacitance. The active area of the photodiode also had to be maintained so that the photodiodes would have a sufficient light absorption area to capture the very weak reflected laser light. Measurements of the series resistance for the custom photodiodes ranged from 11 - 84 ohms and the junction capacitance went as low as 5.8 pico-farads. Further tests showed that an optimal SNR resulted when the series resistance was about 80 ohms and the junction capacitance was about 6.7 pico-farads. (Process variations will cause these values vary by approximately plus or minus 10%.) While these parameters provided optimal noise reduction, other values in this range also provided significant improvements over the standard photodiodes. When the results from custom photodiodes where compared to the standard photodiodes with a series resistance in the range of 161-270 ohms and a junction capacitance in the range of 8.6 - 9.8 pico-farads, the standards photodiodes exhibited 1.8 to 2.3 times more noise than the custom photodiodes. The custom photodiodes had a higher SNR than the standard photodiodes and thus had an improved ability to read small bar codes and had a larger read range.

While the invention is disclosed in the context of a retail bar code scanning embodiment, it will be recognized that a wide variety of implementations may be employed by a person of ordinary skill in the art consistent with the above discussion and the claims, which follow below. In addition, the photodiode maybe used in other applications that would benefit by having a photodiode with lower thermal noise and a higher SNR.

**Claims**

1. A light sensing apparatus, comprising: a semiconductor substrate; a diode fabricated on the semiconductor substrate where the diode has a series resistance of less than 100 ohms and a junction capacitance of less than 8 pico-farads; and a protective package that houses the semiconductor substrate and that has a transparent window allowing light to pass through and strike the diode causing a current to flow.

2. The light sensing apparatus of claim 1, where the diode is fabricated with a p-n junction.

3. The light sensing apparatus of claim 1, where the diode is fabricated with a p-i-n junction.

4. The light sensing apparatus of claim 2, where the series resistance of the diode is between 60-84 ohms.

5. The light sensing apparatus of claim 4, where the junction capacitance of the diode is between 5.8-8 pico-farads.

6. The light sensing apparatus of claim 3, where the series resistance of the diode is between 60-84 ohms.

7. The light sensing apparatus of claim 6, where the junction capacitance of the diode is between 5.8-7.5 pico-farads.

8. The light sensing apparatus of any preceding claim, where the series resistance of the diode is about 80 ohms and the junction capacitance of the diode is about 6.7 pico-farads.

9. A laser scanning system having an improved signal to noise ratio for detecting reflected laser light, the system comprising:

   a laser device adapted to generate a laser beam;
   a beam directing device adapted to direct the laser beam across a code;
   a photodiode adapted to detect reflected laser light from the laser beam moving across the code and to produce electrical signals that are proportional to the detected light where the series resistance of the photodiode is less than 100 ohms and the junction capacitance is less than 8 pico farads; and
   a processor module adapted to process the electrical signals from the photodiode to generate information about the code.

10. The system of claim 19, further comprising a store server adapted to receive the code from the processor and to return information about the code to the processor module.

11. The system of claim 10, where the photodiode is fabricated with a p-n junction.

12. The system of claim 10, where the photodiode is fabricated with a p-i-n junction.

13. The system of claim 11, where the series resistance of the photodiode is between 60-84 ohms.

14. The system of claim 13, where the junction capacitance of the photodiode is between 5.8-8 pico-farads.

15. The system of claim 12, where the series resistance of the photodiode is between 60-84 ohms.

16. The system of claim 15, where the junction capacitance of the photodiode is between 5.8-7.5 pico-farads.

17. The system of any of claim 10, where the series resistance of the photodiode is about 80 ohms and the junction capacitance of the photodiode is about 6.7 pico-farads.

FIG. 1

EP 1 995 782 A2

# FIG. 2

GENERATE A LASER BEAM
DIRECTED AT THE SPINNER
— 200

THE SPINNER DIRECTS THE
LASER BEAM ACROSS THE
BAR CODE
— 210

THE SPINNER DIRECTS
THE REFLECTED LASER BEAM
TO THE PHOTO-DETECTOR
— 220

THE PHOTO-DETECTOR CONVERTS
THE LASER LIGHT SIGNAL TO
AN ELECTRICAL SIGNAL
— 230

THE PROCESSOR MODULE
PROCESSES THE ELECTRICAL SIGNAL
TO DECODE BAR CODE DATA
— 240

THE BAR CODE DATA IS SENT TO
THE STORE SERVER WHICH RETURNS
INFORMATION ABOUT THE BAR CODE
— 250

BAR CODE INFORMATION IS SENT
TO THE DISPLAY
— 260

EP 1 995 782 A2

30

310

305

315    320

**FIG. 3**

325

**FIG. 4**